# EUROPEAN PATENT APPLICATION

(11) **EP 4 379 781 A1**
(43) Date of publication of application: **05.06.2024**
(21) Application number: 23212509.6
(22) Date of filing: 28.11.2023
(51) Int. Cl.: H01L 21/56, H01L 23/31

(54) **METHOD OF MANUFACTURING SEMICONDUCTOR DEVICES AND CORRESPONDING SEMICONDUCTOR DEVICE**

(30) Priority: 30.11.2022 IT 202200024642
(71) Applicant: STMicroelectronics S.r.l., 20864 Agrate Brianza (MB) (IT)
(72) Inventor: ROVITTO, Marco, I-20134 Milano (IT)
(74) Representative: Bosotti, Luciano

(57) **Abstract**

One or more semiconductor dice (14) are arranged on a die pad (12A) of a leadframe (12) having an array of electrically conductive leads (12B) around the die pad (12A). A pattern of electrically conductive wires (16) is provided to couple the semiconductor die or dice (14) with electrically conductive leads (12B) in the array around the die pad (12A). An encapsulation of insulating material (18A, 18B) is provided to encapsulate the semiconductor die or dice (14) arranged on the die pad (12A) and the pattern of electrically conductive wires. Providing the encapsulation comprises:
a first encapsulation step wherein a first mass of encapsulation material (18A) is transferred onto the semiconductor die or dice (14) arranged on the die pad (12A) and onto the pattern of electrically conductive wires (16) to form a core portion (100, 18A) of the encapsulation that fully encapsulates the die or dice (14) and the electrically conductive wires (16), that are thus retained in position by the first mass of encapsulation material (18A), and
a second encapsulation step wherein a second mass of encapsulation material (18B) is molded onto the core portion (100, 18A) of the encapsulation to provide a shell portion (200, 18B) of the encapsulation around the core portion (100, 18A) of the encapsulation.

## Description

### Technical field

The description relates to manufacturing semiconductor devices.

One or more embodiments may be applied to manufacturing semiconductor devices including integrated circuits (ICs), for instance.

### Background

Current manufacturing processes of semiconductor devices include a molding step where a resin or epoxy molding compound (EMC, an epoxy resin, for instance) is molded onto the device to form a protective plastic body.

During the process, resin flow in the mold chase cavity may cause internal voids and wire "sweeping", namely displacement of wires.

These undesired effects may be related to molding process conditions as well as to EMC properties. For instance, in the case of a cascaded arrangement of molding cavities fed from an EMC source, these effects may be more evident at the last filled cavity/cavities in the arrangement due to an increased EMC viscosity.

A center top gate molding technology has been observed to reduce internal voids formation but introduces critical wire sweeping on lateral sides.

Known solutions to wire sweeping issues, like having a first resin dispensed over the wires and cured, followed by injection molding, can be applied in packages with a continuous substrate below the die (like BGA substrates, for example). Such a solution cannot be applied, e.g., in packages like Quad-Flat Package (QFP) Super-Super High Density (SSHD) packages. In fact, a first resin having a low viscosity to go through the high-density mesh of wires would end up by flowing in the space between die pad and leads.

### Object and summary

An object of one or more embodiments is to overcome the drawbacks discussed in the foregoing.

According to one or more embodiments, that object can be achieved via a method having the features set forth in the claims that follow.

One or more embodiments relate to a corresponding semiconductor device.

The claims are an integral part of the technical teaching provided in respect of the embodiments.

Solutions as described herein involve a two-step encapsulation process.

Solutions as described herein may involve a film-assisted molding, where a film is used to form a receiving cavity for a first resin mold, closing the space between die pad and leads. The package is finished by a second molding (overmolding) of molding compound.

### Brief description of the figures

One or more embodiments will now be described, by way of example only, with reference to the annexed figures, wherein:
Figures 1 and 2 are illustrative of steps in manufacturing semiconductor devices,
Figure 3 is an enlarged view of the portion of Figure 2 indicated by arrow III,
Figure 4 is a plan view illustrative of the structure of a semiconductor device according to embodiments of the present description, and
Figures 5A to 5C are illustrative of a sequence of steps of an embodiment of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments. The references used herein are provided merely for convenience and hence do not define the extent of protection or the scope of the embodiments.

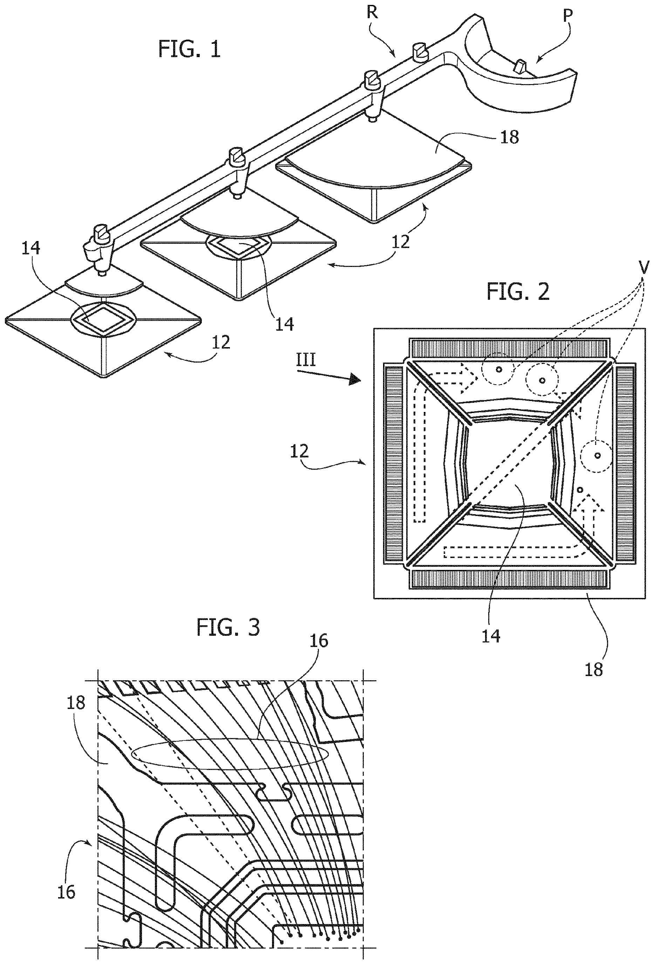

Figures 1 to 3 are illustrative of a process of manufacturing semiconductor devices wherein one or more semiconductor (integrated circuit) chips or dice are arranged onto a substrate, e.g., a leadframe. As used herein, the terms chip/s and die/dice are regarded as synonymous.

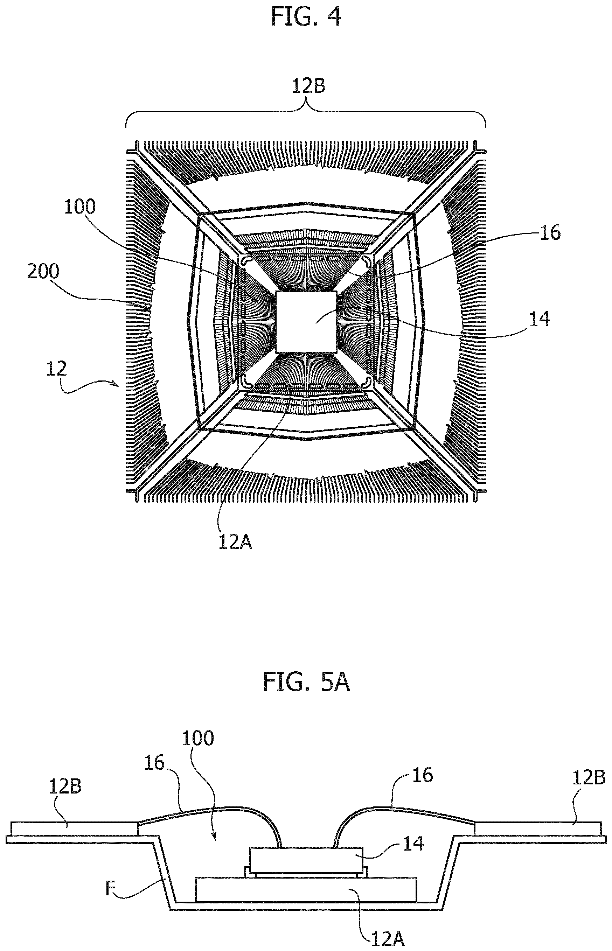

The chip(s), indicated by reference 14 (see Figure 4, for example), are attached on one or more die pads 12A (via die attachment material) in the leadframe 12, with an array of leads 12B around the die pads 12A.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Essentially, a leadframe comprises an array of electrically-conductive formations (or leads, e.g., 12B) that from an outline location extend inwardly in the direction of an (integrated circuit) semiconductor chip or die (e.g., 14) thus forming an array of electrically-conductive formations from a die pad (e.g., 12A) configured to have at least one semiconductor chip or die attached thereon. This may be via conventional means such as a die attach adhesive (a die attach film or DAF, for instance).

Electrically conductive formations are provided to electrically couple the semiconductor chip(s) to selected ones of the leads (outer pads) 12B in the leadframe 12.

Such coupling can be provided via a wire-bonding pattern of wires 16, as conventional in the art.

After forming the electrical couplings between the chip 14 and the leads 12B, encapsulation material (e.g., an epoxy molding compound, EMC) is molded onto the assembly thus formed to provide a protective plastic package to the chip.

Figure 1 is illustrative of such a molding step where a resin (EMC) 18 contained in a resin reservoir (pot) P is caused to flow through a runner line R to a cascaded arrangement of mold cavities each containing a leadframe portion 12 to be molded onto the chips 14 attached thereon to provide a protective encapsulation.

Figure 1 is thus exemplary of current manufacturing processes of semiconductor devices wherein plural devices are manufactured concurrently (to be possibly separated into single individual devices in a final singulation step).

Such a molding process as conventional in the art may undesirably result in internal voids and wire "sweeping".

Figure 2 is illustrative of the formation of internal voids V during the molding step illustrated in Figure 1.

Voids V as illustrated in Figure 2 may result from small air bubbles which may get trapped at the meeting point of different resin flow fronts.

The arrows indicate the direction of the resin flow and voids V can be observed, e.g., in the portion of the leadframe 12 that is last covered by the EMC.

Figure 3 is illustrative of wire sweeping, namely undesired displacement of wires 16 resulting from a conventional molding process as illustrated in Figure 1.

This effect is represented in the case of some exemplary wires 16 by representing the positions of the wires 16 before and after the molding process with dashed and solid lines, respectively.

The drag forces exerted by viscous flow of the molding compound may cause wires 16 to deform, and in worst cases it may cause wires to touch each other, resulting in the failure of the device.

In the case of molding apparatus as illustrated in Figure 1, the effects discussed in the foregoing are mostly observed in the mold cavity or cavities that are farther or farthest away from the resin pot P, due an increase in resin viscosity.

Increasing resin injection speed or increasing the packaging final pressure have been considered in order to counter void formation; however, such a beneficial effect comes at the cost of an increased wire sweeping.

Conversely, increasing the temperature of the EMC or using a different pre-heat time may reduce EMC viscosity, thus slightly reducing wire sweeping, but this does not lead to an appreciable reduction of voids formation.

Other possible approaches involve a modification of the molding equipment; "centre top gate" technology (in contrast to the "corner top gate" molding technology of Figure 1) has been found to reduce void formation but introduces critical wire sweep on lateral side.

Additionally, the solutions discussed previously may be too demanding in terms of cost and/or time.

Solutions discussed herein are based on a two-step encapsulation process comprising a first step performed to mold (only) a core portion of the leadframe where wires are present and a second step where the package of the device is completed by a shell portion molded onto the core portion.

Two different encapsulation techniques may be advantageously used in the two steps in order to solve the issues related to both voids formation and wire sweeping.

It is noted that solutions involving two encapsulation steps are disclosed in documents such as:
L.Roth, et al.: "Wire Encapsulation Improves Fine-Pitch Device Yield", Semiconductor International, vol. 27, No.11, October 2004, and
Y.F. Yao, et al.: "New encapsulation development for fine pitch IC devices", Microelectronics Reliability, Volume 45, Issues 7-8, 2005, Pages 1222-1229,
In the solutions as illustrated in these documents, the first encapsulation step is limited to the wires and does not provide a full encapsulation of the chip or die.

These solutions are applicable only on packages with a "continuous" substrate below the die (a BGA substrate, for example); in fact, the first resin, which has a low viscosity to go through the high-density mesh of wires, would tend to flow in the space between die pad and leads when processing devices having gaps between die pads and leads (e.g., QFP).

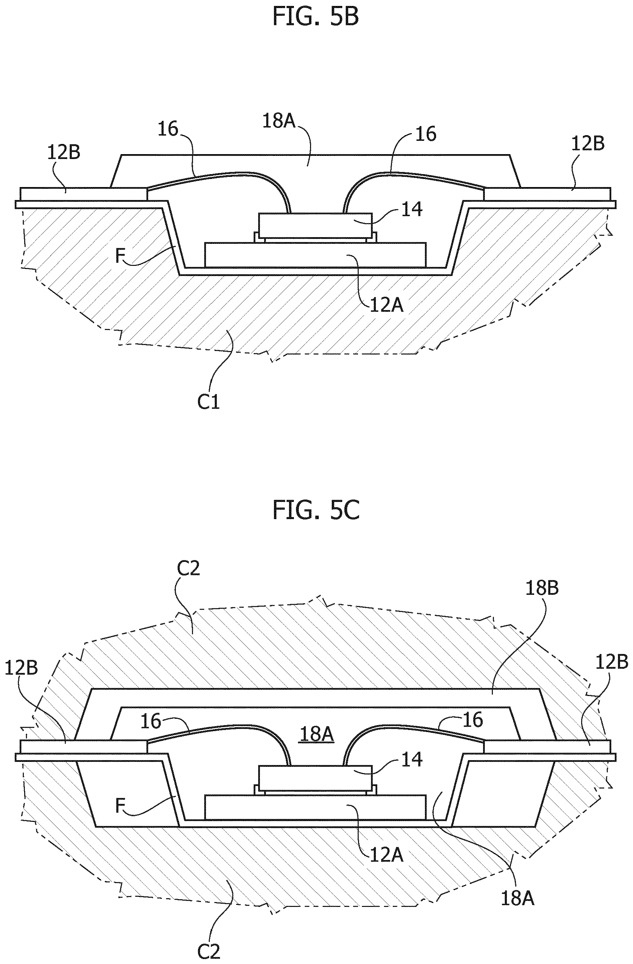

Figure 4 is illustrative of a leadframe 12 (of a device like a QFP-SSHD, for example) with the die 14 mounted on the die pad 12A at a recessed portion of the leadframe 12 (see also Figure 5A). That is, the leadframe 12 as illustrated comprises a die pad 12A having a downset with respect to the array of electrically conductive leads 12B around the die pad 12A.

As discussed in the following, such a leadframe 12A with downset and the array of electrically conductive leads 12B around the die pad are suited to provide a (first) encapsulation cavity wherein a core portion 20A of the device encapsulation can be formed.

For instance, such a leadframe 12A with downset and the array of electrically conductive leads 12B around the die pad form a sort of pan-like structure suited to provide a (first) encapsulation cavity wherein a core portion 20A of the device encapsulation can be formed.

As noted, wires 16 are provided to electrically couple the die bonding pads (not visible in the figures for reasons of scale) on the top/front surface of the die 14 to selected ones of the leads 12B.

As illustrated in Figure 4, the leadframe 12 can be regarded as comprising two regions or portions:
a first, inner core region 100 which contains the wires 16 coupling the die 14 to the leads 12B, and
a second, outer shell region 200 that envelops the inner core region 100 (and thus has no wires extending therethrough).

The sequence of Figures 5A to 5C is illustrative of a two-step encapsulation process that takes advantage of that (e.g., downset) leadframe structure.

It will be otherwise appreciated that the sequence of steps of Figures 5A to 5C is merely exemplary insofar as:
one or more steps illustrated in Figures 5A to 5C can be at least partially omitted, performed in a different manner (with other tools, for instance) and/or replaced by other steps; and
additional steps may be added;
one or more steps can be carried out in a sequence different from the sequence illustrated.

Figure 5A is a cross sectional view of the device illustrated in Figure 4. A die 14 is arranged on the die pad 12A at the recessed portion of the leadframe 12.

The fact that the leadframe illustrated in Figure 5A has a recessed die pad 12A is otherwise merely exemplary of advantageous embodiments of the method described herein. In fact, embodiments as described herein can be applied also to leadframes having no downset between the die pad and the leads.

A release film F, for example a polytetrafluoroethylene film, can be provided on the back or bottom surface of the leadframe 12 in order to facilitate release from a mold cavity C1 (see Figure 5B) used to form a first, core portion of encapsulation 18A embedding the inner core region 100 of the leadframe 12 which contains the wires 16.

Advantageously the film F closes the space between the die pad 12A and the leads 12B thus countering the flow of the first encapsulation material of the core portion 18A therebetween.

Figure 5B is thus illustrative of the result of a first encapsulation step resulting in the encapsulation of the core region 100.

That is, as illustrated, the core portion of the encapsulation encapsulates (fully) the semiconductor die or dice 14 arranged on the die pad 12A as well as the pattern of electrically conductive wires 16. The electrically conductive wires 16 are thus retained in position by the first mass of encapsulation material 18A.

The core region 100 is a (relatively small) region containing (only) the wires 16 and the (first) encapsulation step may be advantageously performed using a technique that reduces the risk of wires sweeping and void formation.

For instance, the first encapsulation step can be performed using laser induced forward transfer (LIFT), which is a deposition process where material from a donor tape or sheet is transferred to an acceptor substrate facilitated by laser pulses.

General information on the LIFT process can be found, for instance, in P. Serra, et al.: "Laser-Induced Forward Transfer: Fundamentals and Applications", in Advanced Materials Technologies/Volume 4, Issue 1.

Another possible choice is liquid mold dispensing (or potting) which is a high-accuracy, non-contact dispensing technique able to work with various viscous materials, such as liquid polymers (for use, e.g., as "underfill" materials), solder paste and the like.

Both these techniques do not involve appreciable movement of the encapsulation material this reducing the risk of both wire sweeping and void formation.

After the first encapsulation step, the first encapsulation material 18A can be solidified (e.g., partially cured) and the assembly formed as illustrated in Figure 5B removed from the cavity C1. The removal is facilitated by the release film F (e.g., a polytetrafluoroethylene film) previously provided.

The assembly can thus be moved to a second cavity C2 where a second encapsulation step can be performed to form an outer shell portion 18B of encapsulation enveloping the core portion 18A previously formed.

In certain embodiments, the first mass of encapsulation material 18A and the second mass of encapsulation material 18B may comprise different encapsulation materials.

As the region 100 of the leadframe containing wires is already encapsulated in the encapsulation material 18A, this second encapsulation step can be performed using conventional techniques (e.g., using conventional EMCs, as discussed in connection with Figure 1).

The second encapsulation step may similarly aim at reducing void formation by increasing the injection speed of the second encapsulation material 18B or by increasing packaging final pressure, with no concerns related to wire sweeping as the wires 16 are already encapsulated in the first encapsulation material 18A.

It is observed that the film F is not removed before the second encapsulation step.

Additional processing steps (not expressly illustrated) may include, e.g., a (post)curing process and a final singulation as conventional in the art.

The two-step process as described herein makes it possible to obtain:
a first encapsulation 18A of the wires 16 in the core region 100 using techniques (such as LIFT or potting) which do not cause appreciable wire sweeping and void formation; and
a second encapsulation 18B of the shell region 200 (having the core region 100 embedded therein) using conventional transfer molding techniques with parameters (such as temperature of the EMC, filling speed and pressure) selected to reduce void formation, while the wires are protected against "sweeping" by being embedded in the first encapsulation 18A.

The device thus obtained will be substantially exempt from both voids and wire sweeping issues.

Without prejudice to the underlying principles, the details and the embodiments may vary, even significantly, with respect to what has been described by way of example only without departing from the scope of the embodiments.

The extent of protection is determined by the annexed claims.

## Claims

1. A method, comprising:
arranging at least one semiconductor die (14) on a die pad (12A) of a leadframe (12), the leadframe (12) having an array of electrically conductive leads (12B) around the die pad (12A),
providing a pattern of electrically conductive wires (16) coupling the at least one semiconductor die (14) with electrically conductive leads (12B) in said array of electrically conductive leads around the die pad (12A), and
providing an encapsulation of insulating material (18A, 18B) encapsulating the at least one semiconductor die (14) arranged on said die pad (12A) and said pattern of electrically conductive wires (16),
wherein providing the encapsulation of insulating material comprises:
a first encapsulation step wherein a first mass of encapsulation material (18A) is transferred onto the at least one semiconductor die (14) arranged on said die pad (12A) and onto said pattern of electrically conductive wires (16) to form a core portion (100, 18A) of the encapsulation, wherein the core portion (100, 18A) of the encapsulation encapsulates the at least one semiconductor die (14) arranged on said die pad (12A) and the pattern of electrically conductive wires (16), with the electrically conductive wires (16) retained in position by the first mass of encapsulation material (18A), and
a second encapsulation step wherein a second mass of encapsulation material (18B) is molded onto the core portion (100, 18A) of the encapsulation to provide a shell portion (200, 18B) of the encapsulation around the core portion (100, 18A) of the encapsulation.

2. The method of claim 1, wherein the first mass of encapsulation material (18A) and the second mass of encapsulation material (18B) comprise different encapsulation materials.

3. The method of claim 1 or claim 2, wherein the first encapsulation step comprises transferring the first mass of encapsulation material (18A) onto the at least one semiconductor die (14) and said pattern of electrically conductive wires (16) via laser induced forward transfer, LIFT processing.

4. The method of claim 1 or claim 2, wherein the first encapsulation step comprises transferring the first mass of encapsulation material (18A) onto the at least one semiconductor die (14) and said pattern of electrically conductive wires (16) via liquid mold dispensing.

5. The method of any of the previous claims, the method comprising performing said first encapsulation step in a first encapsulation cavity (C1) wherein said core portion of the encapsulation (100, 18A) is formed in said first encapsulation cavity (C1).

6. The method of claim 5, comprising
transferring said core portion of the encapsulation (100, 18A) formed in said first encapsulation cavity (C1) to a second encapsulation cavity (C2), and
performing said second encapsulation step in the second encapsulation cavity (C2) wherein said second mass of encapsulation material (18B) is molded onto the core portion (100, 18A) of the encapsulation.

7. The method of claim 5 or claim 6, the method comprising providing the leadframe (12) with a release film (F), preferably a polytetrafluoroethylene film, to facilitate removal of said core portion (100, 18A) of the encapsulation from said first encapsulation cavity (C1) .

8. The method of any of the previous claims, comprising providing said leadframe (12) with said die pad (12A) having a downset with respect to said array of electrically conductive leads (12B) around the die pad (12A) .

9. The method of claim 8, in combination with any one of claims 5 to 7, wherein said leadframe (12) with said downset and said array of electrically conductive leads (12B) around the die pad (12A) provide said first encapsulation cavity (C1) wherein said core portion (100, 18A) of the encapsulation is formed.

10. A device, comprising:
at least one semiconductor die (14) arranged on a die pad (12A) of a leadframe (12), the leadframe (12) having an array of electrically conductive leads (12B) around the die pad (12A),
a pattern of electrically conductive wires (16) coupling the at least one semiconductor die (14) with electrically conductive leads in said array of electrically conductive leads (12B) around the die pad (12A), and
an encapsulation of insulating material encapsulating the at least one semiconductor die (14) arranged on said die pad (12A) and said pattern of electrically conductive wires (16), wherein the encapsulation comprises:
a first mass of encapsulation material (18A) transferred onto the at least one semiconductor die (14) arranged on said die pad (12A) and said pattern of electrically conductive wires (16) to form a core portion (100, 18A) of the encapsulation, wherein the core portion (100, 18A) of the encapsulation encapsulates the at least one semiconductor die (14) arranged on said die pad (12A) and the pattern of electrically conductive wires (16) with the electrically conductive wires (16) retained in position by the first mass of encapsulation material (18A), and
a second mass of encapsulation material (18B) molded onto the core portion (100, 18A) of the encapsulation to provide a shell portion (200, 18B) of the encapsulation around the core portion (100, 18A) of the encapsulation.

11. The device of claim 10, wherein both the first mass of encapsulation material (18A) and the second mass of encapsulation material (18B) are exempt from voids therein.
